# EUROPEAN PATENT SPECIFICATION

(11) **EP 2 104 408 B1**
(45) Date of publication and mention of the grant of the patent: **15.02.2012**
(21) Application number: 07860057.4
(22) Date of filing: 25.12.2007
(51) Int. Cl.: H05K 3/46, B62D 5/04

(54) **MULTILAYER CIRCUIT BOARD AND MOTOR DRIVE CIRCUIT BOARD**
MEHRSCHICHTIGE LEITERPLATTE UND MOTORANTRIEBS-LEITERPLATTE
CARTE À CIRCUIT IMPRIMÉ MULTICOUCHE ET CARTE À CIRCUIT IMPRIMÉ DE COMMANDE DE MOTEUR

(30) Priority: 26.12.2006 JP 2006348738; 03.09.2007 JP 2007227937
(43) Date of publication of application: 23.09.2009
(73) Proprietor: JTEKT Corporation, Osaka-shi Osaka 542-8502 (JP)
(72) Inventor: NAKAI, Motoo, Osaka-shi Osaka 542-8502 (JP); NAGASE, Shigeki, Osaka-shi Osaka 542-8502 (JP)
(74) Representative: TBK
(86) International application number: PCT/JP2007/074828
(87) International publication number: WO 2008/078739

(56) References cited:
- JP-A- 11 112 153
- JP-A- 63 246 897
- JP-A- 2004 179 291
- JP-A- 2006 114 606
- US-A1- 2003 058 630

## Description

### Technical Field

The present invention relates to a multi-layer circuit substrate and a motor drive circuit substrate for an electric power steering system using the multi-layer circuit substrate.

### Background Art

An electric power steering system for a vehicle drives a steering assistance motor so as to obtain an appropriate steering assistance power, depending on the steering torque provided through a steering wheel operated by a driver and the speed of the vehicle. The steering assistance motor is driven by a motor drive circuit built in an electronic control unit (hereinafter abbreviated as ECU). The motor drive circuit controls a large electric power of approximately 500W to 2000W when driving the steering assistance motor.

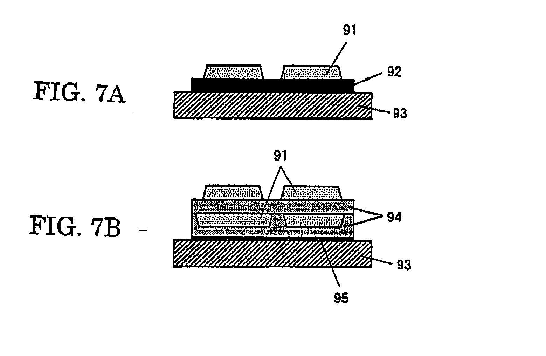

At this time, the motor drive circuit generates heat. In order to prevent a malfunction or a breakdown of the ECU resulting from the heat generation, the motor drive circuit is mounted on a circuit substrate excellent in thermal conductivity. The motor drive circuit is mounted on a metallic circuit substrate which forms one layer of a copper-made conducting layer 91 and one layer of a resin-made insulating layer 92 on a metal substrate 93 (heat sink) made of aluminum, for example, as shown in Fig. 7(a).

Since electronic components are allowed to be mounted only on one side of the circuit substrate shown in Fig. 7(a) (more specifically, on the conducting layer 91), the circuit substrate occupying area becomes large in the ECU. Thus, as a method for reducing a substrate area, a method for making a circuit substrate multi-layered can be considered. However, when the circuit substrate shown in Fig. 7(a) is simply multi-layered, a resin-made insulating layer poor in thermal conductivity is overlaid. As a result, heat generated by electronic components is less likely to be transmitted to the metal substrate 93.

In order to solve the above problem, mounting a motor drive circuit which is mounted on a ceramic multi-layer substrate has been proposed. The ceramic multi-layer substrate shown in Fig. 7(b) is obtained by laminating copper-made conducting layers 91 on ceramic insulating layers 94 to give a multiple layer, and bonding it to an aluminum metal substrate 93 (heat sink) with an adhesive agent 95. This ceramic multi-layer substrate is able to constitute a circuit conductor between the ceramic insulating layers so as to reduce a substrate area.

It is noted that the following prior art is known about the present invention. Japanese Published Unexamined Patent Application No. 9-153679 has disclosed that a heat-sink via hole conductor made of a low-resistance metal material is installed on a laminated glass/ceramic circuit substrate to form a surface conductor on the heat-sink via hole conductor which exposes both principal surfaces of a laminated body. Japanese Published Unexamined Patent Application No. 2004-363183 has disclosed a heat dissipating structure of an electronic component which covers a substrate on which elements are mounted with a heat dissipating plate and a housing, in which a plurality of thermal vias connected to the heat dissipating plate are formed on the substrate. Japanese Published Unexamined Patent Application No. 2004-79883 has disclosed that in place of an insulating layer and a thermal conducting layer, diamond like carbon (DLC) is used.

As described above, a ceramic multi-layer substrate has features including an excellent thermal conductivity and a small substrate area. However, the ceramic multi-layer substrate is higher in cost, which poses a problem. Further, because the ceramic multi-layer substrate easily cracks, a problem arises that a method is required other than fixing the inside of the ECU with a screw.

Document US 2003/058630 A1 (cf. the preamble of claim 1) discloses a multilayer circuit board and a semiconductor device using the same. The multilayer circuit board is for mounting a semiconductor element thereon and comprises a core substrate of a metal material and a plurality of wiring layers stacked on either side of the core substrate, each of the stacked wiring layers being isolated from an adjacent wiring layer by an insulating layer interposed therebetween, the multilayer circuit board having an area at which a heat spreader for dissipating heat generated from the semiconductor element mounted on the circuit board is to be joined to the multilayer circuit board, wherein the multilayer circuit board allows the heat spreader to be joined to the core substrate without the insulating layers being interposed therebetween. A semiconductor device using the multilayer circuit board is also disclosed.

Document JP 2004 179291 A discloses a wiring board and a manufacturing method thereof. In the wiring board, a metal having high heat-dissipation properties such as aluminum is used as a core substrate. Its board thickness has a specific thickness. A through-via penetrated to the core substrate is formed. The core substrate is coated with insulating layers formed by anodizing a surface by an organic acid. Since the insulating layers are composed of extremely thin films, spaces from wiring layers and a conductor layer on the wall surface of the through-via to the core substrate are narrowed.

Document JP 2006 114606 A discloses a printed wiring board, a substrate therefor and a method of manufacturing a substrate for a printed wiring board. A second carbon fiber sheet is superimposed on a first carbon fiber sheet having anisotropy in heat conduction direction such that the heat conduction direction of the second carbon fiber sheet differs from that of the first carbon fiber sheet. Heat dissipation holes are punched that communicate with the carbon sheets, and after the inner walls of the heat dissipation hole are plated with a first metal, a heat conductive resin is filled thereinto.

Document JP 11 1121153 A discloses a multilayered circuit board having a metallic base. The multilayered circuit board is formed so that the board may have via holes and through holes at a rate of 1-100,000 holes/m² and, in addition, one or more lands of the circuit board may have via holes or through holes, so that the total cross section of the conductors sections of each hole may become ≥ 4.0 × 10⁻³ mm² per 1 mm² of land area.

Document JP 63 246897 A discloses a method of manufacturing a metal base double-layer interconnection board.

In view of the above, it is an object of the present invention to provide an improved multi-layer circuit substrate which is lower in cost and excellent in thermal conductivity.

This object is achieved by a multi-layer circuit substrate according to claim 1. Advantageous further developments are as set forth in the dependent claims. Furthermore, a motor drive circuit substrate is defined.

According to one aspect, the conducting layers and the resin-made insulating layers are laminated, thus making it possible to constitute a multi-layer circuit substrate at a lower cost than a ceramic multi-layer substrate. Further, heat generated at the electronic component is transmitted at a high thermal conductivity via the heat dissipating via to the metal substrate. Therefore, it is possible to obtain the multi-layer circuit substrate lower in cost and excellent in thermal conductivity:

According to another aspect, since a resin has the nature of being easily filled, a step for making a hole, a step for forming conducting layers and a step for filling the resin are carried out once with respect to the laminated circuit portion, thus mating it possible to form the heat dissipating via. It is, therefore, possible to form the heat dissipating via more easily than a case where a metal paste or the like is filled.

According to another aspect, since the conducting layers and the resin-made insulating layers are thermal compression bonded, it is possible to form easily the laminated circuit portion by using the existing steps.

According to another aspect, since the lowermost insulating layer and the metal substrate are thermal compression bonded, it is possible to attach the metal substrate firmly to the lowermost insulating layer easily.

According to another aspect, copper which is excellent in thermal conductivity is used to constitute the conducting layers and the heat dissipating via, thus making it possible to improve the thermal conductivity of the multi-layer circuit substrate.

According to another aspect, the copper-made uppermost conducting layer is subjected to gold plating, with nickel plating undercoated, thus making it possible to solder the uppermost conducting layer and provide aluminum wire bonding.

According to another aspect, the electronic component is mounted on the multi-layer circuit substrate lower in cost and excellent in thermal conductivity, by which it is possible to obtain a motor drive circuit substrate which is lower in cost, excellent in thermal conductivity and small in substrate area. Further, a hole for tightening screws is made in the metal substrate to screw the multi-layer circuit substrate to a case.

### Brief Description of the Drawings

Fig. 1 is a cross sectional view showing a multi-layer circuit substrate according to an embodiment of the present invention.
Fig. 2 is a plan view and a cross sectional view showing a heat dissipating via included in the multi-layer circuit substrate shown in Fig. 1.
Fig. 3 is a cross sectional view of another example of the multi-layer circuit substrate according to an embodiment of the present invention.
Figs. 4A to 4F are views showing an example of steps of manufacturing the multi-layer circuit substrate shown in Fig. 1.
Fig. 5 is a cross sectional view showing a motor drive circuit substrate including the multi-layer circuit substrate shown in the Fig. 1.
Fig. 6 is a cross sectional view showing a motor drive circuit substrate including a single layer circuit substrate.
Fig. 7 is a cross sectional view showing a conventional circuit substrate.

### Description of Reference Symbols

11: Conducting layer
12: Insulating layer
13: Laminated circuit portion
14: Metal substrate
15: Gold plating, with nickel plating undercoated
16: Laminated body
21, 24: Heat dissipating via
22: Conducting layer
23: Resin
25: Hole
31: Electronic component

### Best Mode for Carrying Out the Invention

### <Embodiment of the present invention>

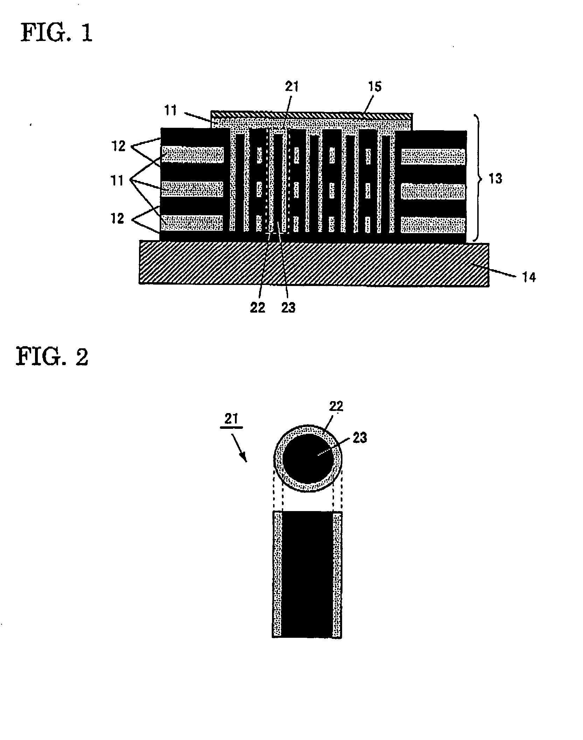

Fig. 1 is a cross sectional view showing a multi-layer circuit substrate according to an embodiment of the present invention. The multi-layer circuit substrate shown in Fig. 1 is provided with a laminated circuit portion 13 formed by laminating alternately conducting layers 11 and insulating layers 12 and also provided with a metal substrate 14. The conducting layer 11 is made of a metal, while the insulating layer 12 is formed of a composite in which an insulating resin is impregnated into glass fiber (so-called prepreg). It is preferable that the conducting layer 11 is made of a metal excellent in thermal conductivity, while the insulating layer 12 is made of a resin having the thermal conductivity of 1 W/m·K or more. In the following description, the conducting layer 11 is to be made of copper and the insulating layer 12 is to be made of a composite of glass fiber and epoxy resin.

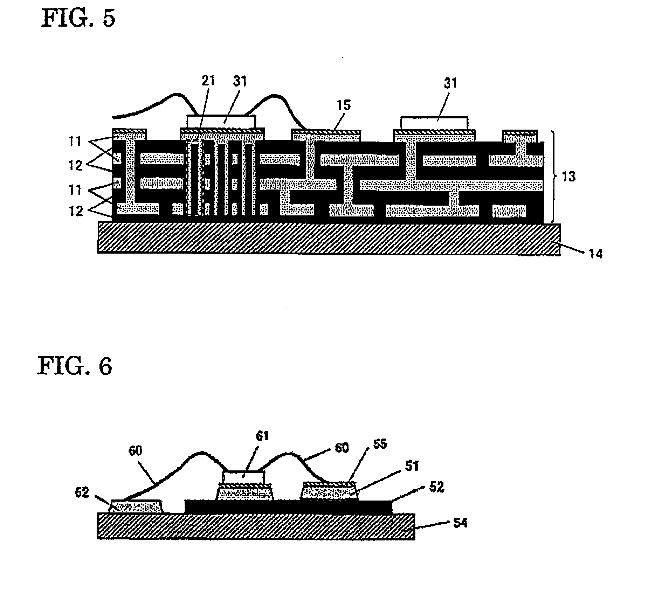

The laminated circuit portion 13 is formed by thermal compression bonding a plurality of conducting layers 11 with a plurality of insulating layers 12. The uppermost layer of the laminated circuit portion 13 is a conducting layer 11 and the lowermost layer is an insulating layer 12. An electronic component is placed on a conducting layer 11 which is the uppermost layer (refer to Fig. 5). In order to solder the electronic component to the copper-made uppermost conducting layer 11, the uppermost conducting layer 11 is subjected to gold plating 15, with nickel plating undercoated.

Further, in order to release the heat generated in the electronic component, a metal substrate 14 is installed below the laminated circuit portion 13 and a heat dissipating via 21 is installed at the laminated circuit portion 13. The metal substrate 14 is made of a metal excellent in thermal conductivity such as aluminum, thereby acting as a heat sink. The metal substrate 14 is installed so as to be in contact with an insulating layer 12, which is the lowermost layer. The lowermost insulating layer 12 and the metal substrate 14 are thermal compression bonded, by which they can be easily firmly attached.

Fig. 2 is a plan view and a cross sectional view of a heat dissipating via 21. The heat dissipating via 21 is an inter-layer connecting hole formed in the thickness direction of conducting layers 11 and insulating layers 12. In more detail, the heat dissipating via 21 is obtained by forming a conducting layer 22 on the inner surface of a through hole penetrating from an insulating layer immediately below a conducting layer 11, which is the uppermost layer, to a conducting layer immediately above an insulating layer 12, which is the lowermost layer, and filling a resin 23 thereinto. The conducting layer 22 is formed by metal plating such as copper plating. A resin (in this case, a composite of glass fiber and epoxy resin) which is the same as that used in forming the insulating layers 12 may be used as the resin 23. The thus formed heat dissipating via 21 connects the uppermost conducting layer 11 on which an electronic component is placed with the lowermost insulating layer 12 via the conducting layer 22 formed on the inner surface.

Electronic components mounted on the multi-layer circuit substrate shown in Fig. 1 include parts great in heating value on operation and parts relatively low in heating value on operation. One or any given number of heat dissipating vias 21 are installed at sites where the electronic components great in heating value are mounted, of these parts. Heat generated at the electronic components is transmitted via the uppermost conducting layer 11 and the conducting layer 22 formed on the inner surface of the heat dissipating via 21 down to the lowermost insulating layer 12, and also transmitted from there to the metal substrate 14. The heat dissipating via 21 acts to transmit the heat generated at the electronic components to an insulating layer immediately above the metal substrate 14 (more specifically, the lowermost insulating layer) 12 at an excellent thermal conductivity.

The heat dissipating via 21 is formed so as to penetrate a conducting layer immediately above an insulating layer 12, which is the lowermost layer, but not penetrate an insulating layer 12, which is the lowermost layer. It is, thereby, possible to prevent a conducting layer 11, which is the uppermost layer, from short-circuiting with the other conducting layer 11, which is the uppermost layer, via the metal substrate 14. The lowermost insulating layer 12 is installed for preventing the short circuit. It is noted that in order to improve the thermal conductivity, the lowermost insulating layer 12 is preferably as thin as possible, as long as it keeps insulation properties.

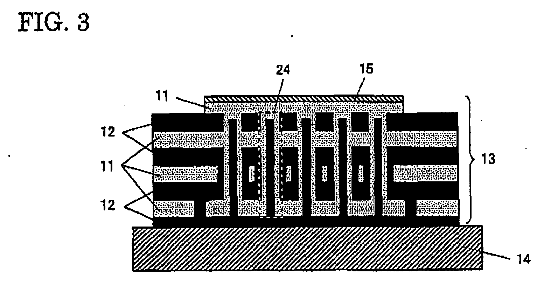

The heat dissipating via 21 shown in Fig. 1 is connected electrically only with a conducting layer 11, which is the uppermost layer. However, the heat dissipating via may be electrically connected with a conducting layer 11 other than the uppermost conducting layer. For example, as shown in Fig. 3, the heat dissipating via 24 is electrically connected also with a third conducting layer 11 (a third layer from above), in addition to the uppermost conducting layer 11. The heat dissipating via 24 is a via electrically connecting the uppermost conducting layer 11 with the third conducting layer 11 which is extended so as to penetrate a conducting layer 11 immediately above an insulating layer 12, which is the uppermost layer. As described above, the via which connects electrically these conducting layers is extended to form a heat dissipating via, thus making it possible to prevent an increase in the substrate area resulting from the installation of heat dissipating vias.

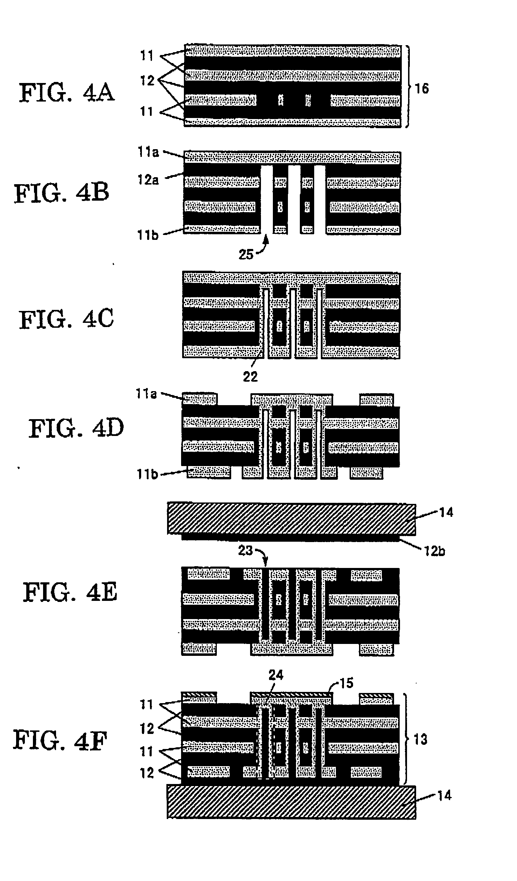

Figs. 4A to 4F are views showing an example of steps of manufacturing the multi-layer circuit substrate according to the present embodiment. Here, as an example, a description will be given for steps of manufacturing a multi-layer circuit substrate which is provided with a laminated circuit portion made up of four conducting layers and four insulating layers and also provided with a heat dissipating via connected electrically with the uppermost conducting layer and a third conducting layer.

First, in the same procedures as those for manufacturing a copper-plated laminated plate, four conducting layers 11 and three sheets of prepregs (those in which an insulating resin is impregnated into a glass cloth), which are given as resin-made insulating layers 12, are alternately laminated, and the copper surface to be in contact with the prepreg is subjected to treatment prior to lamination by using an alkaline oxidation solution (for example, NaClO2 or NaOH), which is further subjected to heating and pressing. Thereby, a seven-ply laminated body 16 (Fig. 4A) is formed. However, before the pressing, a circuit pattern is formed on conducting layers 11, which are given as inner layers, (a third and fifth conducting layers in this example), whenever necessary. As publicly known, the circuit pattern is formed by formation of etching resist or treatment such as etching. In Fig. 4A, a hole is made in advance at a site where a heat dissipating via is to be formed on a fifth conducting layer 11, and the prepreg is held and subjected to pressing, thereby the hole made on the conducting layer 11 is filled with a resin. The pressing carried out at this time may be conducted in a vacuum state, whenever necessary.

Next, a hole 25 is made at a site where the heat dissipating via is to be formed on the laminated body 16 except for only a conducting layer 11a, which is the uppermost layer (Fig. 4B). More specifically, the hole 25 is made which penetrates through a conducting layer 11b, which is the lowermost layer at this time, to an insulating layer 12a immediately below the conducting layer 11a, which is the uppermost layer. Then, the lower side surface of the laminated body 16 and the inner surface of the hole 25 are subjected to treatment necessary prior to cleaning, thereby giving conductive plating such as copper plating. Thus, a conducting layer 22 is formed on the inner surface of the hole 25 (Fig. 4C). Further, a circuit pattern is formed on the uppermost conducting layer 11a of the laminated body 16 and a conducting layer 11b, which is the lowermost layer at this time (Fig. 4D). As publicly known, the circuit pattern is formed by formation of etching resist or treatment such as etching.

After that, the laminated body 16 is turned over, a resin 23 is filled into the hole 25, on which a resin-made prepreg 12b (this is given as the lowermost insulating layer) and a metal substrate 14 which is subjected to rough surface treatment by an oxidation solution are placed, and the thus treated laminated body is heated and pressurized (Fig. 4E). Thereby, the laminated body 16, the insulating layer 12b, and the metal substrate 14 are thermal compression bonded. The metal substrate 14 is subjected to rough surface treatment because the lowermost insulating layer 12b is firmly attached to the metal substrate 14. The lowermost insulating layer 12b is thermal compression bonded to the seven-ply laminated body 16 to form an eight-ply laminated circuit portion 13. By the treatment so far given, the uppermost conducting layer 11 is connected with the lowermost insulating layer 12 by the conducting layer 22 formed on the inner surface to form a heat dissipating via 24 into which the resin 23 is filled.

Finally, the thermal compression bonded laminated circuit portion 13 and the metal substrate 14 are again turned over, the uppermost conducting layer 11 is subjected to necessary prior treatment and subjected to gold plating 15, with nickel plating undercoated (Fig. 4F). The multi-layer circuit substrate according to the present embodiment can be manufactured by the treatment described above.

The multi-layer circuit substrate according to the present embodiment is applied, for example, to a motor drive circuit substrate for an electric power steering system. Fig. 5 is a cross sectional view showing the motor drive circuit substrate including the multi-layer circuit substrate shown in Fig. 1. The motor drive circuit substrate shown in Fig. 5 is used by being built into an ECU (electronic control unit) for an electric power steering system.

The ECU includes a motor control circuit for calculating an amount of driving electric current supplied to a steering assistance motor and a motor drive circuit for controlling a great electric current to drive the steering assistance motor. The motor control circuit will not generate heat in a great amount on operation but the motor drive circuit will generate heat in a relatively great amount on operation. The motor drive circuit is mounted on a motor drive circuit substrate (Fig. 5), while the motor control circuit is mounted on another circuit substrate. These two circuit substrates are arranged in parallel or in two stages inside the ECU.

The motor drive circuit substrate shown in Fig. 5 is a substrate in which an electronic component 31 is placed on a conducting layer 11, which is the uppermost layer, on the multi-layer circuit substrate shown in Fig. 1. The electronic component 31 mounted on the motor drive circuit substrate is provided with a semiconductor chip, a current detecting sensor, a noise removing coil, and relays including a power-off relay and a motor phase-current blocking relay. In addition, all of these electronic components are not necessarily mounted on the motor drive circuit substrate.

Since the uppermost conducting layer 11 made of copper is subjected to gold plating 15, with nickel plating undercoated, it is possible to solder the electronic component 31 to the uppermost conducting layer 11. In this case, in order to decrease a substrate area, a semiconductor chip is preferably mounted as a bare chip. Further, on soldering, a reflow soldering is preferably conducted in a vacuum. Thereby, melted solder is prevented from being mixed with air bubbles to improve the thermal conductivity between the electronic component 31 and the uppermost conducting layer 11.

One or any given number of heat dissipating vias are installed at sites where electronic components 31 are arranged. When an electronic component 31 is soldered to the uppermost conducting layer 11, there is a case where a terminal of the electronic component 31 is soldered and a case where a part other than the terminal of the electronic component 31 (for example, the back surface of a semiconductor chip) is soldered. In the latter case, a heat dissipating via (such as the heat dissipating via 21 shown in Fig. 1) is installed which is electrically connected only with the uppermost conducting layer 11. In the former case, a heat dissipating via (such as the heat dissipating via 24 shown in Fig. 3) is installed which is electrically connected with a conducting layer 11 other than the uppermost layer. It is not necessary to install heat dissipating vias at all sites where electronic components 31 are arranged. On the motor drive circuit substrate shown in Fig. 5, no heat dissipating via is installed at a site where the electronic component 31 on the right side is arranged.

Since the motor drive circuit substrate shown in Fig. 5 is provided with a metal substrate 14, a hole for tightening screws is made in the metal substrate 14, thereby a substrate can be screwed to a case of the ECU, unlike the ceramic multi-layer substrate. Further, the uppermost conducting layer 11 is subjected to gold plating 15, with nickel plating undercoated. Thus, when an external connecting terminal installed on the case of the ECU is electrically connected, the uppermost conducting layer 11 and the external connecting terminal can be subjected to wire bonding by using an aluminum wire.

Hereinafter, a description will be given for effects of the multi-layer circuit substrate and the motor drive circuit substrate according to the present embodiment. Since the multi-layer circuit substrate according to the present embodiment is formed by laminating conducting layers and resin-made insulating layers, it can be manufactured at a lower cost than a ceramic multi-layer substrate in which ceramic substrates are laminated. Further, since the multi-layer circuit substrate according to the present embodiment is provided with a heat dissipating via, heat generated on an electronic component is transmitted at an excellent thermal conductivity via the heat dissipating via to a metal substrate. As described above, the present embodiment is able to provide a multi-layer circuit substrate which is lower in cost and excellent in thermal conductivity.

Further, a resin is filled into the heat dissipating via on the multi-layer circuit substrate according to the present embodiment. Since a resin has the nature of being easily filled, a step for making a hole, a step for metal plating and a step for filling a resin are carried out once with respect to a laminated circuit portion, thus making it possible to form the heat dissipating via. On the other hand, in order to fill a metal paste or the like in a heat dissipating via, it is necessary to carry out a step for making a hole, a step for metal plating and a step for filling a metal paste repeatedly in the course of forming a laminated circuit portion. As described above, the present embodiment is able to form the heat dissipating via in simple steps.

Still further, the conducting layers and the resin-made insulating layers are thermal compression bonded, thus making it possible to form a laminated circuit portion easily in the existing steps. An insulating layer, which is the lowermost layer, and a metal substrate are also thermal compression bonded, by which the metal substrate can be firmly attached to the lowermost insulating layer easily. Copper which is excellent in thermal conductivity is used to constitute the conducting layers and a heat dissipating via, by which a multi-layer circuit substrate can be improved in thermal conductivity. Further, a copper-made conducting layer, which is the uppermost layer, is subjected to gold plating, with nickel plating undercoated, thus making it possible to solder the uppermost conducting layer and also carry out aluminum wire bonding.

In addition, since the motor drive circuit substrate according to the present embodiment is mounted with an electronic component for driving a motor on a multi-layer circuit substrate excellent in thermal conductivity at a low cost, it is lower in cost, and excellent in thermal conductivity and small in substrate area. Further, the motor drive circuit substrate according to the present embodiment is provided with a metal substrate. Thus, a hole for tightening screws is made in the metal substrate, by which the metal substrate can be screwed to a case of an ECU.

### <Modified example>

In the present embodiment, a description was given for a case where the conducting layers 11 are made of copper. In place of copper, the conducting layers may be made of metals such as aluminum, nickel, silver, titanium and gold, their alloys the surface of which is laminated by plating with nickel or nickel/gold. Further, these metals, alloys and laminated films may be formed by pressure bonding, sputtering, chemical vapor deposition, vacuum deposition, thick film printing or a combination of these methods. The thick film printing is preferable, with consideration given to the fact that the conducting layers 11 are approximately 100 □m in thickness.

In the present embodiment, a description was given for a case where all insulating layers 12 inside the laminated circuit portion 13 are made of a prepreg. It is acceptable that only an insulating layer 12, which is the lowermost layer, is made of a diamond like carbon layer (DLC layer). In this case, the DLC layer is made up of an inclined DLC layer in which the silicon containing concentration varies sequentially and a DLC layer is free of silicon. First, the inclined DLC layer is formed on a metal substrate on which a chromium layer or a titanium layer is in advance formed and the DLC layer free of silicon is then formed. The inclined DLC layer is higher in silicon content on the chromium layer (or the titanium layer) (10 to 20at%, for example), gradually lower in silicon content as it moves away from the chromium layer or the titanium layer, and lowest on the inclined DLC layer free of silicon (0-4at%, for example). In this case, the insulating layer 12 can be made extremely thin or as thin as from 1 to 2 □m in thickness to decrease the thermal resistance. Therefore, heat generated from electronic components can be transmitted via heat dissipating vias 21 and 24 at an excellent thermal conductivity to a metal substrate 14. Here, the chromium layer (or the titanium layer) and the inclined DLC layer are held between the metal substrate 14 and the DLC layer free of silicon due to a reason that they are improved in adhesiveness between these layers. Further, a chromium nitride layer may be additionally formed between the chromium layer and the inclined DLC layer. In this case, the DLC layer can be prevented from collapse even on application of a high contact pressure.

Further, the motor drive circuit substrate according to the present embodiment may be fixed by thermal compression bonding the insulating layer 12, which is the lowermost layer, on the laminated circuit portion 13 to a case of an ECU or a metallic housing such as a gear housing. In this case, the necessity for applying thermal grease to decrease the thermal resistance of the substrate 14 against the metal housing or for polishing to improve the surface roughness of the metal substrate 14 can be eliminated, thus making it possible to reduce the cost of manufacturing the motor drive circuit substrate. The necessity for screwing on a housing the metal substrate 14 which supports the laminated circuit portion 13 can be eliminated, thereby eliminating the necessity for making a clearance for tightening screws. By just that much, the motor drive circuit substrate can be downsized accordingly. In addition, the metal substrate 14 acts to support the laminated circuit portion 13 as well. However, since the laminated circuit portion 13 is usually 1 mm or more in thickness, the laminated circuit portion 13 can be easily handled without the metal substrate 14, when thermal compression bonding to the housing.

### <Others>

As shown in Fig. 6, a description will be given for a motor drive circuit substrate in which an insulating layer 52 made up of a DLC is formed on a metal substrate 54 made of aluminum and a metal conducting layer 51 is formed thereon. Any substrate capable of acting as a heat sink may be used as the metal substrate 54, and, for example, a case of an ECU is acceptable. A thin film such as a chromium layer or a titanium layer is formed in advance on the metal substrate 54 by sputtering or others. Thereafter, formed is an inclined DLC layer which is higher in silicon content on the chromium layer (or the titanium layer) (10 to 20at%, for example), gradually lower as it moves away from the chromium layer or the titanium layer and lowest at the end (0 to 4at%, for example). Then, a DLC free of silicon is formed thereon. Since the thus formed film of the insulating layer 52 is quite thin, for example, 1 to 2 □m in thickness, the thermal resistance is decreased and heat generated at an electronic component 61 can be transmitted at an excellent thermal conductivity to the metal substrate 54. Further, a chromium nitride layer may be additionally formed between the chromium layer and the inclined DLC layer. In this case, the DLC layer can be prevented from collapse even when a high contact pressure is applied.

Then, the conducting layer 51 is formed on the surface of the insulating layer 52. The conducting layer 51 is made of copper, aluminum, nickel, silver, titanium, gold, an alloy of two or more of these metals or their alloys the surface of which is plated with nickel or nickel/gold. Further, these metals and others may be formed by pressure bonding, sputtering, chemical vapor deposition, vacuum deposition or thick film printing or a combination of these methods. The thick film printing is preferable, with consideration given to the fact that the conducting layer 51 is approximately 100 □m in thickness.

Further, as shown in Fig. 6, the conducting layer 51 is subjected to gold plating 55, with nickel plating undercoated and, thereafter, an electronic component 61 is mounted on the surface of the conducting layer 51. In order to electrically connect electronic components with the other conducting layer 51 and an external connecting terminal 62 installed on the metal substrate 54 such as a case of an ECU, the electronic component 61, the conducting layer 51 and the external connecting terminal 62 are respectively subjected to wire bonding by using an aluminum wire 60.

## Claims

1. A multi-layer circuit substrate comprising:
a laminated circuit portion (13) in which conducting layers (11) and resin-made insulating layers (12) are alternately laminated;
a metal substrate (14) configured to act as a heat sink and provided so as to be in contact with the lowermost insulating layer (12); and
a heat dissipating via (21, 24) which connects the uppermost conducting layer (11) on which an electronic component (31) is placed with the lowermost insulating layer (12) by using a conducting layer (22) formed on an inner surface of the heat dissipating via (21, 24),
wherein a resin (23) is filled in the heat dissipating via (21, 24),
**characterized in that**
the portion of the surface of the metal substrate (14) facing the laminated circuit portion (13) is completely covered by the lowermost insulating layer (12), and
the heat dissipating via (21, 24) is formed in the laminated circuit portion so as to penetrate conducting layers (11) and insulating layers (12) except the uppermost conducting layer (11) and also except the lowermost insulating layer (12) covering the surface of the metal substrate (14), and to not penetrate the metal substrate.

2. The multi-layer circuit substrate according to claim 1, wherein the laminated circuit portion (13) is formed by thermal compression bonding the conducting layers (11) and the resin-made insulating layers (12).

3. The multi-layer circuit substrate according to claim 1, wherein the lowermost insulating layer (12) and the metal substrate (14) are thermal compression bonded.

4. The multi-layer circuit substrate according to claim 1, wherein the conducting layer (11) of the laminated circuit portion (13) and the conducting layer (22) formed on the inner surface of the heat dissipating via (21, 24) are made of copper.

5. The multi-layer circuit substrate according to claim 1, wherein the uppermost conducting layer (11) is subjected to gold plating with nickel plating undercoated.

6. The multi-layer circuit substrate according to claim 1, wherein the lowermost insulating layer (12) is made of a diamond like carbon layer instead of resin-made insulating layer.

7. The multi-layer circuit substrate according to claim 1, wherein
the diamond like carbon layer includes an inclined diamond like carbon layer in which silicon containing concentration varies sequentially and is formed on a chromium layer or titanium layer formed on the metal substrate (14), and a diamond like carbon layer which does not contain silicon and which is formed on the inclined diamond like carbon, and
the inclined diamond like carbon layer is formed on the chromium layer or the titanium layer in such a manner that the inclined diamond like carbon layer is higher in silicon content on the chromium layer or the titanium layer and gradually lowers in silicon content as it moves away from the chromium layer or the titanium layer.

8. The multi-layer circuit substrate according to any of claims 1 to 7, wherein a surface of the metal substrate (14) in contact with the lowermost insulating layer (12) is subjected to rough surface treatment.

9. A motor drive circuit substrate for an electric power steering system comprising:
a multi-layer circuit substrate according to any of claims 1 to 8; and
an electronic component (31) placed on the uppermost conducting layer (11) of the laminated circuit portion (13).

## Patentansprüche

1. Mehrschichtiges Schaltkreissubstrat, mit:
einem laminierten Schaltkreisabschnitt (13), in dem leitende Schichten (11) und aus Harz hergestellte isolierende Schichten (12) abwechselnd laminiert sind;
einem Metallsubstrat (14), das derart konfiguriert ist, um als eine Wärmesenke zu fungieren und derart angeordnet ist, dass es in Kontakt mit der untersten isolierenden Schicht (12) ist; und
einem Wärmeabführdurchgang (21, 24), der die oberste leitende Schicht (11), auf der eine elektronische Komponente angeordnet wird, mit der untersten isolierenden Schicht (12) unter Verwendung einer auf einer inneren Oberfläche des Wärmeabführdurchgangs (21, 24) gebildeten leitenden Schicht (22) verbindet,
wobei ein Harz (23) in den Wärmeabführdurchgang (21, 24) gefüllt ist,
**dadurch gekennzeichnet, dass**
der dem laminierten Schaltkreisabschnitt (13) zugewandte Abschnitt der Oberfläche des Metallsubstrats (14) vollständig durch die unterste isolierende Schicht (12) bedeckt ist, und
der Wärmeabführdurchgang (21, 24) in dem laminierten Schaltkreisabschnitt gebildet ist, um leitende Schichten (11) und isolierende Schichten (12) mit Ausnahme der obersten leitenden Schicht (11) und der die Oberfläche des Metallsubstrats (14) bedeckenden untersten isolierenden Schicht (12) zu durchdringen, und um nicht das Metallsubstrat zu durchdringen.

2. Mehrschichtiges Schaltkreissubstrat nach Anspruch 1, wobei der laminierte Schaltkreisabschnitt (13) durch thermisches Druck-Kleben der leitenden Schichten (11) und der aus Harz hergestellten isolierenden Schichten (12) gebildet ist.

3. Mehrschichtiges Schaltkreissubstrat nach Anspruch 1, wobei die unterste isolierende Schicht (12) und das Metallsubstrat (14) thermisch druck-geklebt sind.

4. Mehrschichtiges Schaltkreissubstrat nach Anspruch 1, wobei die leitende Schicht (11) des laminierten Schaltkreisabschnitts (13) und die auf der inneren Oberfläche des Wärmeabführdurchgangs (21, 24) gebildete leitende Schicht (22) aus Kupfer hergestellt sind.

5. Mehrschichtiges Schaltkreissubstrat nach Anspruch 1, wobei die oberste leitende Schicht (11) einem Goldüberzug mit einem darunterliegenden Nickelüberzug unterzogen ist.

6. Mehrschichtiges Schaltkreissubstrat nach Anspruch 1, wobei die unterste isolierende Schicht (12) aus einer diamant-ähnlichen Kohlenstoffschicht anstelle einer aus Harz hergestellten isolierenden Schicht hergestellt ist.

7. Mehrschichtiges Schaltkreissubstrat nach Anspruch 1, wobei
die diamant-ähnliche Kohlenstoffschicht eine geneigte diamant-ähnliche Kohlenstoffschicht aufweist, in der sich eine Konzentration enthaltenen Siliziums sequenziell ändert, und die auf einer auf dem Metallsubstrat (14) gebildeten Chromschicht oder Titanschicht gebildet ist, und eine diamant-ähnliche Kohlenstoffschicht aufweist, die kein Silizium enthält und die auf dem geneigten diamant-ähnlichen Kohlenstoff gebildet ist, und
die geneigte diamant-ähnliche Kohlenstoffschicht auf der Chromschicht oder der Titanschicht derart gebildet ist, dass die geneigte diamant-ähnliche Kohlenstoffschicht mehr Silizium auf der Chromschicht oder der Titanschicht enthält, und der Gehalt an Silizium mit zunehmender Entfernung von der Chromschicht oder der Titanschicht allmählich sinkt.

8. Mehrschichtiges Schaltkreissubstrat nach einem der Ansprüche 1 bis 7, wobei eine Oberfläche des Metallsubstrats (14) in Kontakt zu der untersten isolierenden Schicht (12) einer rauen Oberflächenbehandlung unterzogen ist.

9. Motorantriebsschaltkreissubstrat für ein elektrisches Servolenkungssystem, mit:
einem mehrschichtigen Schaltkreissubstrat nach einem der Ansprüche 1 bis 8; und
einer auf der obersten leitenden Schicht (11) des laminierten Schaltkreisabschnitts (13) angeordneten elektrischen Komponente (31).

## Revendications

1. Substrat de circuit multicouches comprenant :
une partie (13) de circuit stratifiée dans laquelle des couches conductrices (11) et des couches isolantes (12) de résine sont stratifiées en alternance ;
un substrat métallique (14) configuré pour agir comme dissipateur de chaleur et prévu de façon à être en contact avec la couche d'isolation (12) la plus basse ; et
un trou d'interconnexion (21, 24) de dissipation de chaleur qui relie la couche conductrice (11) la plus haute sur laquelle un composant électronique (31) est placé et la couche d'isolation (12) la plus basse en utilisant une couche conductrice (22) formée sur une surface intérieure du trou d'interconnexion (21, 24) de dissipation de chaleur,
dans lequel le trou d'interconnexion (21, 24) de dissipation de chaleur est rempli de résine (23),
**caractérisé en ce que**
la partie du substrat métallique (14) faisant face à la partie (13) de circuit stratifiée est complètement recouverte par la couche d'isolation (12) la plus basse, et
le trou d'interconnexion (21, 24) de dissipation de chaleur est formé dans la partie de circuit stratifiée de façon à pénétrer dans des couches conductrices (11) et des couches d'isolation (12) à l'exception de la couche conductrice (11) la plus haute et aussi à l'exception de la couche d'isolation (12) la plus basse couvrant la surface du substrat métallique (14), et sans pénétrer dans le substrat métallique.

2. Substrat de circuit multicouches selon la revendication 1, dans lequel la partie (13) de circuit stratifiée est formée par compression thermique liant les couches conductrices (11) et les couches d'isolation (12) en résine.

3. Substrat de circuit multicouches selon la revendication 1, dans lequel la couche d'isolation (12) la plus basse et le substrat métallique (14) sont liés par compression thermique.

4. Substrat de circuit multicouches selon la revendication 1, dans lequel la couche conductrice (11) de la partie (13) de circuit stratifiée et la couche conductrice (22) formées sur la surface intérieure du trou d'interconnexion (21, 24) de dissipation de chaleur sont en cuivre.

5. Substrat de circuit multicouches selon la revendication 1, dans lequel la couche conductrice (11) la plus haute est soumise à une dorure avec nickelage de la couche de fond.

6. Substrat de circuit multicouches selon la revendication 1, dans lequel la couche d'isolation (12) la plus basse est faite d'une couche de carbone de type diamant au lieu d'une couche isolante faite de résine.

7. Substrat de circuit multicouches selon la revendication 1, dans lequel
la couche de carbone de type diamant comprend une couche de carbone de type diamant inclinée dans laquelle la concentration de silicium varie séquentiellement et est formée sur une couche de chrome ou une couche de titane formée sur le substrat métallique (14), et une couche de carbone de type diamant qui ne contient pas de silicium et qui est formée sur le carbone de type diamant inclinée, et
la couche de carbone de type diamant est formée sur la couche de chrome ou la couche de titane de manière que la couche de carbone de type diamant ait une teneur plus élevée en silicium sur la couche de chrome ou la couche de titane et la teneur en silicium diminue progressivement lorsqu'on s'éloigne de la couche de chrome ou de la couche de titane.

8. Substrat de circuit multicouches selon l'une quelconque des revendications 1 à 7, dans lequel une surface du substrat métallique (14) en contact avec la couche d'isolation (12) la plus basse est soumise à un traitement de surface rugueuse.

9. Substrat de circuit d'entraînement de moteur pour un système de direction assistée électrique comprenant :
un substrat de circuit multicouches selon l'une quelconque des revendications 1 à 8 ;
un composant électronique (31) placé sur la couche conductrice (11) la plus haute de la partie (13) de circuit stratifiée.
